# FASCICULE DE BREVET EUROPEEN

(11) **EP 2 141 117 B1**
(45) Date de publication et mention de la délivrance du brevet: **08.05.2013**
(21) Numéro de dépôt: 09163971.6
(22) Date de dépôt: 29.06.2009
(51) Int. Cl.: B81C 1/00

(54) **Procédé d'encapsulation d'un dispositif microélectronique par un materiau getter**
Einkapselungsverfahren einer mikroelektronischen Vorrichtung mit Hilfe eines Getter-Materials
Method for encapsulating a microelectronic device with a getter material

(30) Priorité: 01.07.2008 FR 0854449
(43) Date de publication de la demande: 06.01.2010
(73) Titulaire: Commissariat à l'Énergie Atomique et aux Énergies Alternatives, 75015 Paris (FR)
(72) Inventeur: Caplet, Stéphane, 38360, Sassenage (FR); Baillin, Xavier, 38920, Crolles (FR); Pornin, Jean-Louis, 38920, Crolles (FR)
(74) Mandataire: Ilgart, Jean-Christophe

(56) Documents cités:
- EP-A- 1 878 693
- US-A1- 2003 138 656

## Description

### DOMAINE TECHNIQUE

L'invention concerne un procédé d'encapsulation de dispositifs microélectroniques par un matériau getter, permettant notamment la réalisation d'un packaging en couches minces d'un dispositif microélectronique dans une cavité sous vide ou sous atmosphère contrôlée.

### ÉTAT DE LA TECHNIQUE ANTÉRIEURE

Un matériau getter est un matériau comportant, de façon intrinsèque et/ou de par sa morphologie microscopique, des propriétés absorbantes et/ou adsorbantes vis-à-vis des molécules gazeuses, pouvant ainsi former une pompe de gaz chimique lorsque celui-ci est disposé dans un environnement clos. Ce type de matériau peut également être utilisé dans de nombreuses applications microélectroniques telles que les tubes à vide, les systèmes à effet de champ ou encore les MEMS (microsystèmes électromécaniques) ou NEMS (nanosystèmes électromécaniques), pour réaliser un environnement sous vide poussé ou sous atmosphère contrôlée (contrôle du gaz et/ou de la pression). Dans le cas des MEMS ou NEMS encapsulés, un environnement sous vide poussé formé autour du dispositif permet par exemple d'obtenir un meilleur fonctionnement des systèmes mécaniques résonnants, mais aussi des systèmes optiques sensibles à l'absorption du rayonnement lumineux par les gaz environnants, ou pour des raisons d'isolation thermique par exemple dans le cas de bolomètres.

Des matériaux getter non évaporables sont par exemple des métaux tels que du titane, du zirconium, de l'hafnium, du vanadium ou encore des alliages métalliques de ces quatre métaux ou d'autres métaux adaptés. Un tel matériau getter non évaporable est généralement déposé directement sur une paroi de l'enceinte dans laquelle on cherche à réaliser une pompe chimique sous la forme d'une couche mince. Ce matériau est ensuite activé thermiquement en le chauffant. Le document US 6 923 625 B2 décrit la réalisation d'une telle couche mince de matériau getter sur un substrat. Toutefois, un tel procédé nécessite de réaliser ensuite un assemblage du substrat comportant la couche de matériau getter avec le substrat sur lequel est réalisé le dispositif destiné à être enfermé dans l'enceinte, ce qui peut être un inconvénient majeur.

Le matériau getter peut également être déposé dans la cavité où se trouve le dispositif microélectronique, par exemple sur le substrat, à côté du dispositif. La cavité est ensuite refermée par des couches minces formant un capot. Le document FR 2 822 541 A décrit un tel procédé. Un tel procédé a notamment pour inconvénient que la surface du matériau getter est limitée par la présence du dispositif sur le substrat. De plus, le matériau getter est ici co-intégré au dispositif, ce qui limite les technologies pouvant être utilisées pour réaliser le matériau getter et le dispositif : par exemple, incompatibilité de mise en oeuvre d'un process chaud ou d'une chimie agressive par rapport au matériau getter pour la réalisation du dispositif microélectronique.

Le document EP 1 878 693 A1 décrit également un autre procédé connu d'encapsulation utilisant un matériau getter.

### EXPOSÉ DE L'INVENTION

Un but de la présente invention est de proposer un procédé d'encapsulation d'un dispositif microélectronique permettant d'obtenir une grande surface d'absorption de matériau getter, ne nécessitant pas d'assemblage de substrats entre eux et qui ne pose pas de problème de compatibilité technologique entre les techniques de réalisation du matériau getter et du dispositif microélectronique.

Pour cela, la présente invention propose un procédé d'encapsulation d'un dispositif microélectronique disposé sur un substrat, comportant au moins les étapes suivantes :
a) réalisation d'une portion de matériau sacrificiel recouvrant au moins une partie, ou la totalité, du dispositif microélectronique et dont le volume occupe un espace destiné à former au moins une partie d'une cavité dans laquelle le dispositif est destiné à être encapsulé,
b) dépôt d'une couche à base d'au moins un matériau getter, recouvrant au moins une partie, ou la totalité, de la portion de matériau sacrificiel,
c) réalisation d'au moins un orifice à travers au moins la couche de matériau getter, formant un accès à la portion de matériau sacrificiel,
d) élimination, par exemple par gravure, de la portion de matériau sacrificiel par l'orifice, formant la cavité dans laquelle le dispositif microélectronique est encapsulé,
e) fermeture de la cavité, par exemple par un dépôt d'un matériau obstruant au moins l'orifice.

Ainsi, on intègre une couche de matériau getter dont la face arrière du dépôt est mise à nue dans la cavité encapsulant le dispositif microélectronique. L'utilisation d'une couche de matériau getter déposée au-dessus du dispositif microélectronique permet d'obtenir une plus grande surface de matériau getter présente dans la cavité par rapport aux procédés de l'art antérieur.

On peut ainsi utiliser toute la surface nécessaire dans la cavité pour l'effet getter. De plus, le matériau getter est intégré en post-process packaging, c'est-à-dire après la réalisation du dispositif microélectronique, ce qui donne plus de latitude aux techniques pouvant être utilisées pour réaliser le dispositif microélectronique (exemples : process chaud, chimie agressive par rapport au matériau getter,...), et cela sans nécessiter un assemblage de deux substrats distincts pour former la cavité.

De plus, avec ce procédé, c'est la face arrière de la couche de matériau getter qui réalise la fonction d'absorption gazeuse, contrairement aux procédés d'encapsulation de l'art antérieur dans lesquels c'est uniquement la face avant de la couche de matériau getter qui remplit la fonction d'absorption gazeuse.

Selon l'invention, on obtient ainsi un dispositif microélectronique encapsulé dans une cavité fermée comportant un matériau getter intégré dont la face inférieure est disposée en regard du dispositif microélectronique. On forme un empilement de couches superposées, par exemple des couches minces, formant le capot de la cavité et comportant le matériau getter. Le dispositif microélectronique peut être un élément actif mécaniquement et/ou électriquement, tel qu'un MEMS, NEMS, MOEMS (microsystèmes opto-électromécaniques), un capteur optique (notamment un capteur optique infrarouge), une structure d'émission, un accéléromètre, un gyromètre ou autre.

Ce procédé permet donc d'encapsuler un dispositif microélectronique dans un environnement sous vide poussé, permettant par exemple un meilleur fonctionnement du dispositif microélectronique lorsque celui-ci est un microsystème mécanique résonant, ou sous pression contrôlée d'un gaz, par exemple d'azote, permettant par exemple un meilleur fonctionnement du dispositif microélectronique lorsque celui-ci est par exemple un microsystème optique sensible à la conduction thermique des gaz résiduels.

L'étape a) de réalisation de la portion de matériau sacrificiel peut comporter au moins la mise en oeuvre des étapes suivantes :
a1) dépôt d'une couche à base du matériau sacrificiel sur le substrat et recouvrant au moins le dispositif microélectronique,
a2) mise en forme d'une partie de la couche sacrificielle, une portion restante de la couche sacrificielle pouvant former ladite portion de matériau sacrificiel.

Cette mise en forme peut être obtenue, lorsque la couche sacrificielle est à base d'un matériau photosensible (par exemple une résine, un polymère, ...), par photolithographie et développement. Lorsque la couche sacrificielle est à base d'un matériau non photosensible (par exemple du Cu, de l'Al, ...), cette mise en forme peut être obtenue par gravure de la couche sacrificielle selon des motifs préalablement définis par un masque.

Le procédé peut comporter en outre, entre l'étape a) de réalisation de la portion de matériau sacrificiel et l'étape b) de dépôt de la couche de matériau getter, une étape de fluage thermique de la portion de matériau sacrificiel. Un tel fluage thermique permet « d'adoucir » les angles de cette portion de matériau sacrificiel et donc d'obtenir de meilleurs passages de marches au niveau des angles de cette portion sacrificielle, améliorant donc le recouvrement de la ou des couches déposées ultérieurement sur la portion de matériau sacrificiel et améliorant également l'herméticité et la solidité de la cavité réalisée.

Le procédé peut comporter en outre, entre l'étape a) de réalisation de la portion de matériau sacrificiel et l'étape b) de dépôt de la couche de matériau getter, une étape de dépôt d'une couche de protection sur la portion de matériau sacrificiel, la couche de matériau getter étant déposée, au cours de l'étape b), sur la couche de protection, l'orifice étant en outre réalisé, au cours de l'étape c), à travers la couche de protection.

Selon un mode de réalisation, au moins une partie de la couche de protection peut être gravée ou non au cours de l'étape d). Dans un mode de réalisation dans lequel une seconde cavité est réalisée au-dessus de la couche de matériau getter, cette couche de protection peut-être conservée. Par contre, dans un autre mode de réalisation ne réalisant qu'une seule cavité, cette couche de protection est au moins partiellement éliminée. Cette couche de protection peut permettre de ne pas détériorer le matériau getter lors de la gravure du matériau sacrificiel.

Le procédé peut comporter en outre, entre l'étape b) de dépôt de la couche de matériau getter et l'étape c) de réalisation de l'orifice, une étape de dépôt d'une couche d'herméticité sur la couche de matériau getter, l'orifice pouvant être en outre réalisé, au cours de l'étape c), à travers la couche d'herméticité. Une telle couche d'herméticité permet d'améliorer l'herméticité de la cavité dans laquelle est encapsulé le dispositif microélectronique.

Le procédé peut comporter en outre, entre l'étape b) de dépôt de la couche de matériau getter et l'étape de dépôt de la couche d'herméticité, une étape de gravure d'une partie de la couche de matériau getter, une portion restante de la couche de matériau getter recouvrant partiellement la portion de matériau sacrificiel. Ainsi, on structure le matériau getter de manière localisée, permettant la réalisation d'une fenêtre optique face au dispositif microélectronique lorsque celui-ci est un dispositif optique.

La couche d'herméticité peut avoir une épaisseur comprise entre environ 500 nm et 10 µm, et/ou être à base de titane et/ou de chrome et/ou de cuivre et/ou d'au moins un métal et/ou à base d'un matériau transparent à une plage de longueurs d'ondes de fonctionnement du dispositif microélectronique.

Le procédé peut comporter en outre, entre l'étape b) de dépôt de la couche de matériau getter et l'étape c) de réalisation de l'orifice, une étape de gravure d'une partie de la couche ou des couches réalisées sur la portion de matériau sacrificiel, les portions restantes de ladite ou desdites couches déposées pouvant former un capot ou une partie d'un capot recouvrant la portion de matériau sacrificiel.

L'étape e) de fermeture peut comporter le dépôt d'une couche d'un matériau et/ou la réalisation d'au moins un bouchon, obstruant l'orifice sur le matériau getter ou sur la couche d'herméticité.

Le matériau et/ou le bouchon obstruant l'orifice peuvent être à base d'un métal et/ou d'un oxyde et/ou d'un matériau getter.

Le procédé peut comporter en outre, au cours de l'étape a) de réalisation de la portion de matériau sacrificiel, la formation, par exemple par une gravure, d'au moins un second orifice dans la portion de matériau sacrificiel, les couches déposées au cours des étapes ultérieures pouvant être également déposées dans ledit second orifice, pouvant former au moins un micro-pilier dans la cavité, améliorant ainsi la solidité de la cavité dans laquelle est encapsulé le dispositif microélectronique.

La portion de matériau sacrificiel peut avoir une épaisseur comprise entre environ 1 µm et 20 µm, et/ou le matériau sacrificiel pouvant être à base de résine photosensible ou d'au moins un métal.

La couche de matériau getter peut avoir une épaisseur comprise entre environ 200 nm et 5 µm, et/ou le matériau getter pouvant être à base de titane et/ou de zirconium et/ou d'hafnium et/ou de vanadium.

Le procédé peut comporter en outre, après l'étape e) de fermeture de la cavité, une étape d'activation thermique du matériau getter.

Dans un autre mode de réalisation, le procédé peut comporter en outre, entre l'étape c) de réalisation de l'orifice et l'étape d) d'élimination, ou entre l'étape d) d'élimination et l'étape e) de fermeture, les étapes suivantes :
- réalisation d'une seconde portion de matériau sacrificiel sur la couche de matériau getter ou sur la couche d'herméticité, dont le volume occupe un espace destiné à former au moins une partie d'une seconde cavité,
- dépôt d'une seconde couche à base d'au moins un matériau getter et/ou d'une couche d'herméticité recouvrant au moins une partie de la seconde portion de matériau sacrificiel,
- réalisation d'au moins un second orifice à travers au moins la seconde couche de matériau getter et/ou la couche d'herméticité, formant un accès à la seconde portion de matériau sacrificiel,
   et comportant en outre, entre l'étape de réalisation du second orifice et l'étape d) d'élimination, ou pendant l'étape d) d'élimination, ou entre l'étape d) d'élimination et l'étape e) de fermeture, une étape d'élimination d'au moins la seconde portion de matériau sacrificiel par le second orifice, formant la seconde cavité.

Dans ce mode de réalisation, la deuxième cavité est en communication avec l'autre cavité dans laquelle est disposé le dispositif microélectronique. Dans ce mode de réalisation, la face avant et/ou la face arrière de la couche getter peuvent donc assurer une fonction d'absorption gazeuse, permettant ainsi d'augmenter encore la surface active du matériau getter.

La réalisation de la seconde portion de matériau sacrificiel peut comporter au moins la mise en oeuvre des étapes suivantes :
- dépôt d'une seconde couche à base du matériau sacrificiel sur la couche de matériau getter ou sur la couche d'herméticité, au niveau d'au moins une partie du dispositif microélectronique,
- mise en forme d'une partie de la seconde couche sacrificielle, une portion restante de la seconde couche sacrificielle formant ladite seconde portion de matériau sacrificiel.

Le procédé peut comporter en outre, avant l'étape de dépôt de la seconde couche de matériau getter et/ou de la couche d'herméticité, la mise en oeuvre d'une étape de fluage thermique de la seconde portion de matériau sacrificiel.

Le procédé peut comporter en outre, entre l'étape de réalisation de la seconde portion de matériau sacrificiel et l'étape de dépôt de la seconde couche de matériau getter et/ou de la couche d'herméticité, une étape de dépôt d'une seconde couche de protection sur la seconde portion de matériau sacrificiel, la seconde couche de matériau getter et/ou la couche d'herméticité étant ensuite déposées sur la seconde couche de protection, le second orifice étant en outre réalisé à travers la seconde couche de protection.

La couche de protection et/ou la seconde couche de protection peuvent par exemple avoir chacune une épaisseur comprise entre environ 10 nm et 1 µm et/ou être à base de chrome et/ou de cuivre.

Le procédé peut comporter en outre, entre l'étape de dépôt de la seconde couche de matériau getter et/ou de la couche d'herméticité et l'étape de réalisation du second orifice, une étape de gravure d'une partie de la couche ou des couches réalisées sur la seconde portion de matériau sacrificiel, les portions restantes de ladite ou desdites couches déposées formant un capot ou une partie d'un capot recouvrant la seconde portion de matériau sacrificiel.

La portion de matériau sacrificiel et/ou la seconde portion de matériau sacrificiel peuvent avoir chacune une épaisseur comprise entre environ 1 µm et 20 µm, et/ou le matériau sacrificiel pouvant être à base de résine photosensible ou d'au moins un métal.

La couche de matériau getter et/ou la seconde couche de matériau getter peuvent avoir chacune une épaisseur comprise entre environ 200 nm et 5 µm, et/ou le matériau getter pouvant être à base de titane et/ou de zirconium et/ou d'hafnium et/ou de vanadium.

L'étape e) de fermeture peut comporter le dépôt d'une couche d'un matériau et/ou la réalisation d'au moins un bouchon, obstruant le second orifice sur la seconde couche de matériau getter et/ou sur la couche d'herméticité.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1E représentent les étapes d'un procédé d'encapsulation d'un dispositif microélectronique, objet de la présente invention, selon un premier mode de réalisation,
- la figure 2 représente un dispositif microélectronique encapsulé selon un procédé, objet de la présente invention, selon une variante du premier mode de réalisation,
- les figures 3A à 3C représentent les étapes d'un procédé d'encapsulation d'un dispositif microélectronique, objet de la présente invention, selon un second mode de réalisation,
- la figure 4 représente un dispositif microélectronique encapsulé selon un procédé, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

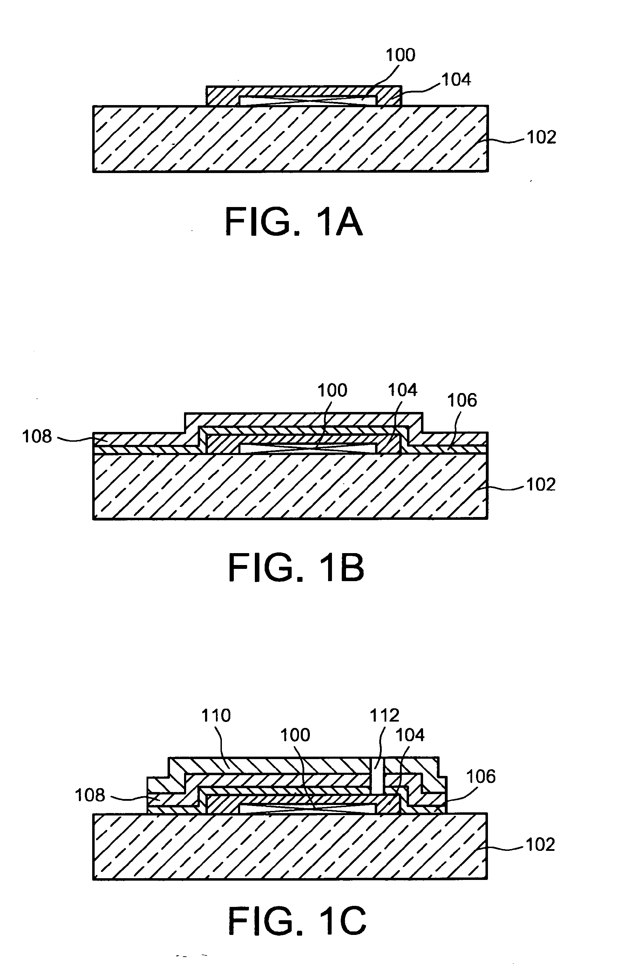

On se réfère tout d'abord aux figures 1A à 1E qui représentent les étapes d'un procédé d'encapsulation d'un dispositif microélectronique 100 selon un premier mode de réalisation. Dans ce premier mode de réalisation, le dispositif microélectronique 100 est un MEMS.

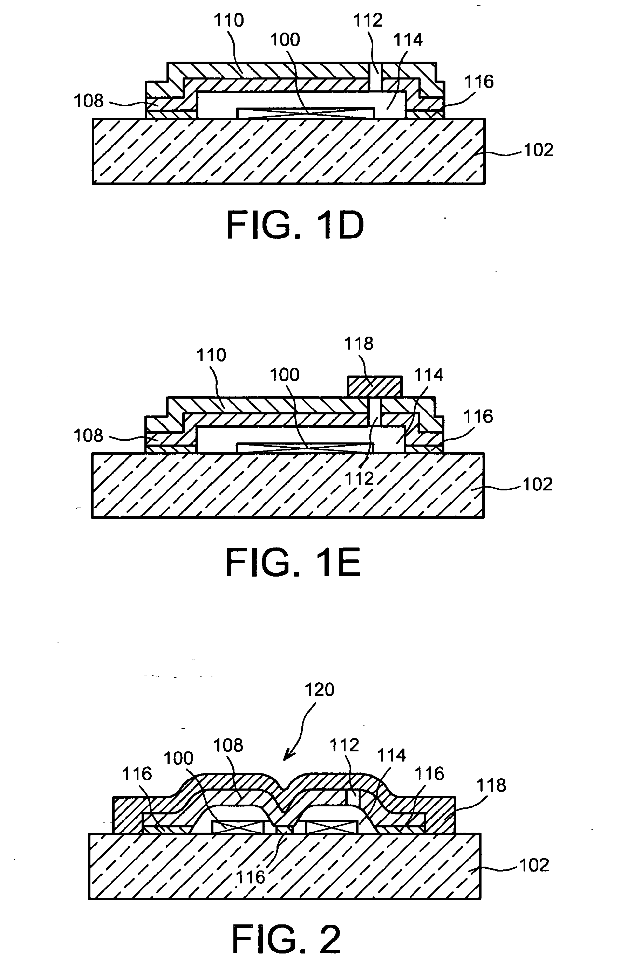

Sur la figure 1A, on réalise tout d'abord le dépôt d'une couche à base d'un matériau sacrificiel sur le dispositif microélectronique 100, précédemment réalisé sur un substrat 102 par exemple à base de semiconducteur tel que du silicium ou du verre. Dans ce premier mode de réalisation, le matériau sacrificiel est à base de résine photosensible. Toutefois, cette couche sacrificielle peut être à base de n'importe quel matériau pouvant être éliminé sélectivement par rapport aux autres matériaux en présence lors de l'élimination ultérieure de ce matériau sacrificiel (représentée sur la figure 1D), par exemple un métal tel que du cuivre. L'épaisseur de la couche sacrificielle peut être de quelques micromètres, par exemple comprise entre environ 1 µm et 20 µm. L'épaisseur de la couche sacrificielle est notamment choisie en fonction de la hauteur souhaitée de la cavité dans laquelle est destiné à être encapsulé le dispositif microélectronique 100.

Cette couche sacrificielle est ensuite structurée, par exemple par insolation lorsque la couche sacrificielle est à base de résine photosensible, ou lithographie lorsque la couche sacrificielle est à base d'un métal, et gravure. Cette structuration permet à une portion restante 104 de la couche sacrificielle recouvrant le dispositif microélectronique 100 de former un « moule » pour la future cavité dans laquelle le dispositif microélectronique 100 est destiné à être encapsulé.

Après cette structuration, et lorsque la couche sacrificielle est à base de résine, il est possible de réaliser un fluage thermique de cette portion de matériau sacrificiel 104 afin d'obtenir de meilleurs passages de marches au niveau des angles formés par cette portion de matériau sacrificiel 104. Ce fluage thermique peut être réalisé dans une étuve, à une température comprise entre environ 250°C et 350°C.

Sur la figure 1B, on réalise ensuite le dépôt d'une couche de protection 106, puis le dépôt d'une couche 108 à base de matériau getter, sur le substrat 102 et sur la portion 104 de matériau sacrificiel. La couche de protection 106 a notamment pour but de protéger la couche de matériau getter 108 lorsque l'on réalisera ultérieurement la gravure de la portion de matériau sacrificiel 104. Toutefois, dans une variante de ce premier mode de réalisation, il est possible de ne pas déposer de couche de protection 106, et donc de déposer directement la couche de matériau getter 108 sur le substrat 102 et sur la portion de matériau sacrificiel 104. Cette couche de protection 106 pourra notamment être omise lorsque le matériau sacrificiel peut être éliminé sans endommager la couche de matériau getter 108.

La couche de protection 106 est par exemple à base de chrome et a une épaisseur pouvant être comprise entre environ 10 nm et 1 µm. La couche de protection 106 peut être déposée par PVD (dépôt physique en phase vapeur) et par exemple par pulvérisation. Dans le cas où cette couche de protection 106 est ensuite éliminée sur tout ou partie de la couche de matériau getter 108, cette couche 106 peut être à base de tout matériau pouvant être gravé sans endommager le dispositif microélectronique 100 et en préservant une couche de matériau getter d'épaisseur suffisante (par exemple supérieure à environ 200 nm) dans le cas où elle est partiellement gravée. Si le matériau de la couche de protection 106 implique d'être gravé par une gravure humide, le dispositif microélectronique 100 doit également être compatible avec la mise en oeuvre, après la gravure de la couche de protection 106, d'une étape de séchage, c'est-à-dire présenter une tenue mécanique suffisante par rapport aux forces de capillarité induites lors de cette étape de séchage. Il sera dans ce cas possible de réaliser une couche de protection 106 par exemple à base de cuivre.

Il est possible, au cours de la suite du procédé, que la couche de protection 106 ne soit pas éliminée après le retrait de la couche sacrificielle. En effet, lorsque la couche de matériau getter 108 comporte du titane et/ou que la couche de protection 106 comporte du cuivre et/ou du chrome et/ou du niobium, et/ou que la couche de protection 106 présente une épaisseur comprise entre quelques nanomètres et quelques dizaines de nanomètres (par exemple comprise entre 1 nm et 100 nm ou entre 1 nm et 50 nm), cette couche de protection 106 peut être conservée car le matériau getter peut interagir, à travers une telle couche de protection 106, avec le milieu présent dans la cavité. Dans une variante, la couche de protection 106 peut être en partie éliminée afin qu'elle présente au plus une épaisseur critique au-delà de laquelle le matériau getter n'interagit plus à travers la couche de protection 106. Dans tous les cas, la couche de protection 106 peut être formée par une seule couche ou par un empilement de plusieurs couches en particulier lorsqu'elle est partiellement éliminée.

La couche de matériau getter 108 peut être à base de n'importe quel matériau getter, par exemple du titane et/ou du zirconium et/ou de l'hafnium, et/ou de l'aluminium et/ou du baryum et/ou du cérium et/ou du chrome et/ou du cobalt et/ou du fer et/ou du magnésium et/ou du manganèse et/ou du molybdène et/ou du niobium et/ou du tantale et/ou du thallium et/ou du vanadium et/ou du tungstène et/ou tout autre matériau pouvant présenter des propriétés d'absorption gazeuse. Cette couche de matériau getter 108 peut avoir une épaisseur comprise entre environ 200 nm et 5 µm.

Ces deux dépôts sont réalisés de préférence dans le même cycle de vide, c'est-à-dire que la structure sur laquelle sont déposées les couches 106 et 108 n'est pas remise à l'air libre et reste sous vide dans la machine de dépôt entre ces deux étapes de dépôt afin d'éviter la présence de particules polluantes à l'interface des deux couches 106 et 108. On assure ainsi une très bonne qualité de la face de la couche de matériau getter 108 se trouvant en contact avec la couche de protection 106 et destinée à former une paroi de la cavité dans laquelle le dispositif microélectronique 100 sera encapsulé.

On dépose ensuite une couche d'herméticité 110 sur la couche de matériau getter 108. Cette couche d'herméticité 110 est par exemple à base de titane, de chrome ou encore de cuivre, ou encore à base d'un matériau métallique, et peut avoir une épaisseur comprise entre environ 500 nm et 10 µm.

Lorsque le dispositif microélectronique 100 est un dispositif optique (MOEMS, capteur optique, dispositif d'affichage, ...), le matériau de la couche d'herméticité 110 peut être transparent ou au moins partiellement transparent aux longueurs d'ondes de fonctionnement du dispositif microélectronique 100. La couche d'herméticité 110 est par exemple dans ce cas un oxyde déposé par PECVD (dépôt chimique en phase vapeur assisté par plasma) ou de l'Al₂O₃ déposé en ALD (dépôt de couches atomiques), l'épaisseur de cette couche d'herméticité 110 étant alors adaptée en fonction des taux d'herméticité et de transparence requis pour le dispositif microélectronique 100.

Les trois couches 106, 108 et 110 sont ensuite structurées par exemple par lithographie et gravure afin de former la structure du capot de protection destiné à encapsuler le dispositif microélectronique 100.

Enfin, des orifices 112 sont réalisés à travers ces trois couches 106, 108 et 110 afin de former un accès à la couche sacrificielle 104. Sur la figure 1C, un seul orifice 112 est représenté. Ces orifices 112 peuvent être répartis au-dessus du matériau sacrificiel 104 ou déportés à côté de la portion de matériau sacrificiel 104 si celle-ci est accessible par le côté. De préférence, les étapes de réalisation des orifices 112 et la structuration des couches 106, 108 et 110 seront mises en oeuvre simultanément.

La portion de matériau sacrificiel 104 est ensuite gravée afin de former une cavité 114 dans laquelle est encapsulé le dispositif microélectronique 100 (figure 1D). On grave également les parties de la couche de protection 106 se trouvant au niveau de la cavité 114, par exemple par une gravure sèche par plasma ozone lorsque la couche de protection 106 est à base de chrome ou par une gravure humide à partir d'une solution de FeCl₃ lorsque la couche de protection 106 est à base de cuivre. Sur la figure 1D, des portions restantes 116 de cette couche de protection 106 forment une partie des parois latérales de la cavité 114.

Ainsi, la face arrière de la couche de matériau getter 108, c'est-à-dire la face qui était au préalable en contact avec la couche de protection 106, est mise à nue, formant notamment une paroi principale supérieure de la cavité 114. L'absorption de gaz dans la cavité 114 pourra donc être réalisée par cette face arrière de la couche de matériau getter 108.

Enfin, des bouchons 118 sont réalisés sur la couche d'herméticité 110 afin de boucher les orifices 112 et donc de fermer hermétiquement la cavité 114. Sur la figure 1E, seul un bouchon 118 est représenté. Si l'on cherche à avoir un vide poussé, par exemple une pression inférieure à environ 1 mbar dans la cavité 114, le bouchon 118 sera de préférence réalisé par un dépôt métallique par évaporation sous vide pour qu'au moment du bouchage le vide soit déjà présent dans la cavité 114. Dans une variante, les bouchons 118 peuvent être à base d'un matériau getter, contribuant ainsi à l'absorption gazeuse dans la cavité 114. Si l'on souhaite que l'atmosphère de la cavité 114 soit exempte de gaz réactif tel que de l'O₂, les bouchons 118 peuvent être réalisés par un dépôt par pulvérisation d'argon (l'argon résiduel n'étant pas gênant dans ce cas là). Enfin, il est également possible de réaliser les bouchons 118 par un dépôt d'oxyde par PECVD.

Dans une variante de ce procédé, il est possible de ne pas déposer de couche d'herméticité 110 sur la couche de matériau getter 108. Dans ce cas, le capot de protection du dispositif 100 peut n'être formé que par la couche de matériau getter 108 et éventuellement des portions résiduelles 116 de la couche de protection 106. Dans cette variante, il est alors possible que les bouchons 118 soient formés par une couche recouvrant l'ensemble de la couche de matériau getter 108, et remplissant donc le même rôle de capot que la couche d'herméticité 110.

Une fois que la cavité est fermée hermétiquement, on réalise alors une activation thermique du matériau getter 108 afin que celui-ci réalise une absorption des molécules gazeuses se trouvant dans la cavité 114. Cette activation thermique peut être réalisée en exposant le matériau getter à une température comprise entre environ 250°C et 450°C.

Dans une variante de réalisation, les couches déposées pour encapsuler le dispositif microélectronique 100 peuvent former dans la cavité 114 des micro-piliers de soutien judicieusement répartis dans la cavité 114, consolidant mécaniquement le capot encapsulant le dispositif 100. La figure 2 représente un exemple de dispositif 100 encapsulé dans une cavité 114 dans laquelle sont formés des micro-piliers 120. Sur cette figure 2, un seul micro-pilier 120 est représenté. Ces micro-piliers 120 sont obtenus en structurant la portion de matériau sacrificiel 104 (c'est-à-dire en réalisant des orifices dans cette portion de matériau sacrificiel 104) de manière à ce que des portions de la couche de matériau getter 108 et, lorsque celles-ci sont présentes, des portions 116 de la couche de protection 106 et/ou des portions de la couche d'herméticité 110 et/ou des portions d'une couche 118 formant les bouchons forment les micro-piliers 120 disposés dans la cavité 114.

Dans l'exemple de la figure 2, l'encapsulation du dispositif 100 est réalisée sans la couche d'herméticité 110, et le bouchage de l'orifice 112 est réalisé par une couche 118 recouvrant l'ensemble de la couche de matériau getter 108.

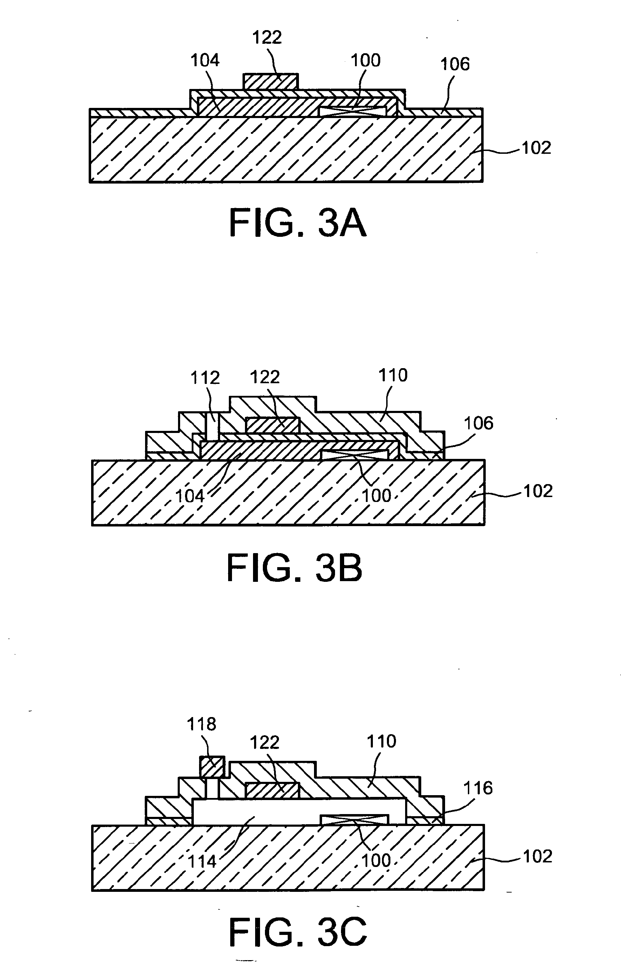

On se réfère maintenant aux figures 3A à 3C qui représentent les étapes d'un procédé d'encapsulation d'un dispositif microélectronique 100 selon un second mode de réalisation.

On réalise tout d'abord les mêmes étapes que celles précédemment décrites en liaison avec les figures 1A et 1B, c'est-à-dire le dépôt d'une couche sacrificielle sur un dispositif microélectronique 100 réalisé sur un substrat 102, la structuration de la couche sacrificielle pour obtenir une portion 104 de matériau sacrificiel, puis le dépôt d'une couche de protection 106 sur la portion de matériau sacrificiel 104 et le dépôt d'une couche de matériau getter 108 sur la couche de protection 106. Comme représenté sur la figure 3A, on réalise ensuite une structuration de la couche de matériau getter 108 afin de conserver une ou plusieurs portions 122 de cette couche 108 ne recouvrant que partiellement la couche de protection 106. Là encore, dans une variante de réalisation, il est possible de ne pas déposer la couche de protection 106 et de déposer directement la couche de matériau getter 108 sur la portion de matériau sacrificiel 104. Sur l'exemple de la figure 3A, une seule portion 122 de matériau getter est conservée. Les dimensions et la forme de la portion 122 de matériau getter sont choisies en fonction de la quantité de gaz à absorber dans la cavité 114 : plus un vide important est requis dans la cavité 114, plus cette portion 122 aura des dimensions importantes.

Comme représenté sur la figure 3B, on réalise ensuite le dépôt de la couche d'herméticité 110 sur la couche de protection 106 ainsi que sur la portion 122 de matériau getter. Une structuration par lithographie et gravure de la couche d'herméticité 110 et de la couche de protection 106 permet alors de délimiter le capot du dispositif 100. On réalise également des ouvertures 112 à travers les couches d'herméticité 110 et de protection 106 afin de former des accès à la couche sacrificielle 104. Etant donné que seule une portion 122 de matériau getter est utilisée dans ce second mode de réalisation, on réalisera de préférence les ouvertures 112 telles qu'elles ne traversent pas la portion 122.

Les portions de la couche de protection 106 se trouvant au niveau de la future cavité 114 sont alors gravées, ainsi que la portion de matériau sacrificiel 104, formant ainsi la cavité 114. Enfin, comme dans le premier mode de réalisation, les orifices 112 sont ensuite bouchés par des bouchons 118 réalisés sur la couche d'herméticité 110 (figure 3C).

Par rapport au premier mode de réalisation, ce second mode de réalisation permet, par exemple lorsque que le dispositif microélectronique 100 est un dispositif optique, d'éviter que le matériau getter ne se trouve dans le champ optique du dispositif 100. Ainsi, en choisissant une couche d'herméticité 110 à base d'un matériau transparent ou partiellement transparent aux longueurs d'onde de fonctionnement du dispositif 100, on obtient ainsi un dispositif 100 microélectronique intégré sous vide et comportant une fenêtre optique lui permettant d'émettre et/ou recevoir un rayonnement optique.

Les variantes précédemment décrites en liaison avec le premier mode de réalisation (présence ou non de la couche de protection 106, présence ou non de la couche d'herméticité 110, bouchage des orifices 112 par une couche recouvrant l'ensemble du capot, réalisation de micro-piliers 120 dans la cavité 114) peuvent également s'appliquer à ce seconde mode de réalisation.

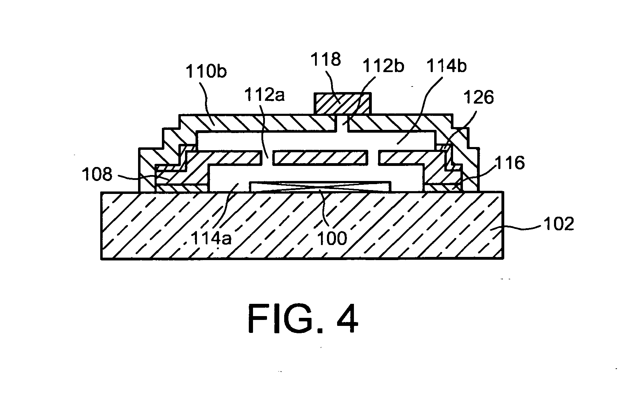

On se réfère à la figure 4 qui représente un dispositif microélectronique 100 encapsulé selon un procédé d'encapsulation, selon un troisième mode de réalisation.

Dans ce troisième mode de réalisation, on réalise plusieurs cavités, par exemple empilées les unes au-dessus des autres. Sur l'exemple de la figure 4, le dispositif 100 est encapsulé dans une première cavité 114a, au-dessus de laquelle est formée une seconde cavité 114b, ces deux cavités 114a, 114b communiquant par l'intermédiaire d'un ou plusieurs orifices 112a ou structurations réalisés dans la couche de matériau getter 108.

Pour réaliser ce type d'encapsulation, les étapes précédemment décrites en liaison avec les figures 1A à 1C sont tout d'abord mises en oeuvre : dépôt et structuration d'une couche sacrificielle sur le dispositif microélectronique 100 pour former une portion de matériau sacrificiel, puis le dépôt d'une couche de protection et d'une couche de matériau getter 108 sur la portion de matériau sacrificiel. Ces couches sont ensuite structurées de façon à ce qu'elles forment un ou plusieurs orifices 112a (les orifices pouvant être de n'importe qu'elle forme) à travers la couche de matériau getter 108 et la couche de protection, et former ainsi un accès à la portion de matériau sacrificiel.

Comme dans les précédents modes de réalisation, lorsque la couche sacrificielle est à base de résine, il est possible de réaliser un fluage thermique de cette portion de matériau sacrificiel avant le dépôt de la couche de protection et/ou de la couche de matériau getter 108 sur la portion de matériau sacrificiel. Dans une autre variante, il est également possible de déposer directement la couche de matériau getter 108 sur le substrat 102 et sur la portion de matériau sacrificiel 104. Enfin, la réalisation du ou des orifices 112a est mise en oeuvre de préférence simultanément à la structuration des couches précédemment déposées.

On dépose ensuite une seconde couche sacrificielle sur la couche de matériau getter 108, puis on réalise une structuration de cette seconde couche sacrificielle pour former une seconde portion de matériau sacrificiel. Cette seconde portion de matériau sacrificiel peut être ou non à base du ou des mêmes matériaux que la portion de matériau sacrificiel précédemment réalisée. Une seconde couche de protection est ensuite déposée sur cette seconde portion de matériau sacrificiel, et enfin une couche d'herméticité 110 est déposée sur la seconde couche de protection. Ces couches sont ensuite structurées par exemple par lithographie et gravure afin de former le reste de la structure du capot de protection. Un ou plusieurs seconds orifices 112b sont ensuite réalisés à travers la couche d'herméticité 110 et la seconde couche de protection, formant ainsi un accès à la seconde portion de matériau sacrificiel.

Dans une variante, il est possible de ne pas utiliser la seconde couche de protection et de déposer directement la couche d'herméticité 110 sur la seconde portion de matériau sacrificiel. La réalisation du ou des seconds orifices 112b est mise en oeuvre de préférence simultanément à la structuration de la seconde couche de protection et de la couche d'herméticité 110. La couche d'herméticité 110 peut également être remplacée par une seconde couche de matériau getter afin d'avoir une plus grande surface getter dans la seconde cavité 114b.

On élimine ensuite successivement la première et la seconde portion de matériau sacrificiel à travers les orifices 112b et 112a, ainsi que les parties des couches de protection se trouvant au niveau des cavités 114a, 114b et ainsi former les deux cavités 114a, 114b superposées. Des portions restantes 116 et 126 des couches de protection forment une partie des parois latérales de cavités 114a, 114b. Dans une variante, la première portion de matériau sacrificiel peut être éliminée avant le dépôt des couches destinées à former le capot de la seconde cavité 114b (seconde couche de protection, seconde couche de matériau getter ou couche d'herméticité).

Le ou les seconds orifices 112b sont ensuite bouchés par un ou plusieurs bouchons 118, réalisés par exemple de manière similaire aux bouchons réalisés dans les précédents modes de réalisation.

Dans ce troisième mode de réalisation, la couche de matériau getter 108 permet de réaliser une absorption gazeuse dans les deux cavités 114a, 114b, chacune des faces de la couche de matériau getter 108 réalisant l'absorption dans les cavités 114a, 114b.

Les couches utilisées dans ce troisième mode de réalisation sont par exemple de nature similaire et/ou de dimensions similaires à celles décrites en liaison avec les précédents modes de réalisation.

Dans une variante de ce troisième mode de réalisation, il est possible de disposer un second dispositif microélectronique dans la seconde cavité 114b, en le disposant sur la couche de matériau getter 108 avant le dépôt des couches permettant de former la seconde cavité 114b. De plus, le ou les orifices 112a formés dans la couche getter 108 peuvent être en nombre plus important et/ou présenter des sections plus importantes que celles des orifices 112b formés dans la couche d'herméticité 110 étant donné que ces orifices 112a ne sont pas destinés à être bouchés.

De manière générale, les différentes variantes précédemment décrites en liaison avec les deux premiers modes de réalisation s'appliquent également à ce troisième mode de réalisation (présence ou non des couches de protection, réalisation de micro-piliers dans l'une ou plusieurs cavités, bouchons formés par une couche de matériau, ...).

## Revendications

1. Procédé d'encapsulation d'un dispositif microélectronique (100) disposé sur un substrat (102), comportant au moins les étapes suivantes :
a) réalisation d'une portion de matériau sacrificiel (104) recouvrant au moins une partie du dispositif microélectronique (100) et dont le volume occupe un espace destiné à former au moins une partie d'une cavité (114, 114a) dans laquelle le dispositif (100) est destiné à être encapsulé,
b) dépôt d'une couche (108) à base d'au moins un matériau getter, recouvrant au moins une partie de la portion de matériau sacrificiel (104),
c) réalisation d'au moins un orifice (112, 112a) à travers au moins la couche de matériau getter (108), formant un accès à la portion de matériau sacrificiel (104),
d) élimination de la portion de matériau sacrificiel (104) par l'orifice (112, 112a), formant la cavité (114, 114a) dans laquelle le dispositif microélectronique (100) est encapsulé,
e) fermeture de la cavité (114, 114a).

2. Procédé selon la revendication 1, dans lequel l'étape a) de réalisation de la portion de matériau sacrificiel (104) comporte au moins la mise en oeuvre des étapes suivantes :
a1) dépôt d'une couche à base du matériau sacrificiel sur le substrat (102) et recouvrant au moins le dispositif microélectronique (100),
a2) mise en forme d'une partie de la couche sacrificielle, une portion restante de la couche sacrificielle formant ladite portion de matériau sacrificiel (104).

3. Procédé selon l'une des revendications précédentes, comportant en outre, entre l'étape a) de réalisation de la portion de matériau sacrificiel (104) et l'étape b) de dépôt de la couche de matériau getter (108), une étape de fluage thermique de la portion de matériau sacrificiel (104).

4. Procédé selon l'une des revendications précédentes, comportant en outre, entre l'étape a) de réalisation de la portion de matériau sacrificiel (104) et l'étape b) de dépôt de la couche de matériau getter (108), une étape de dépôt d'une couche de protection (106) sur la portion de matériau sacrificiel (104), la couche de matériau getter (108) étant déposée, au cours de l'étape b), sur la couche de protection (106), l'orifice (112, 112a) étant en outre réalisé, au cours de l'étape c), à travers la couche de protection (106).

5. Procédé selon la revendication 4, dans lequel la couche de protection (106) a une épaisseur comprise entre environ 10 nm et 1 µm et/ou est à base de chrome et/ou de cuivre.

6. Procédé selon l'une des revendications précédentes, comportant en outre, entre l'étape b) de dépôt de la couche de matériau getter (108) et l'étape c) de réalisation de l'orifice (112, 112a), une étape de dépôt d'une couche d'herméticité (110) sur la couche de matériau getter (108), l'orifice (112, 112a) étant en outre réalisé, au cours de l'étape c), à travers la couche d'herméticité (110).

7. Procédé selon la revendication 6, comportant en outre, entre l'étape b) de dépôt de la couche de matériau getter (108) et l'étape de dépôt de la couche d'herméticité (110), une étape de gravure d'une partie de la couche de matériau getter (108), une portion restante (122) de la couche de matériau getter (108) recouvrant partiellement la portion de matériau sacrificiel (104).

8. Procédé selon l'une des revendications 6 ou 7, dans lequel la couche d'herméticité (110) a une épaisseur comprise entre environ 500 nm et 10 µm, et/ou est à base de titane et/ou de chrome et/ou de cuivre et/ou d'au moins un métal et/ou à base d'un matériau transparent à une plage de longueurs d'ondes de fonctionnement du dispositif microélectronique (100).

9. Procédé selon l'une des revendications précédentes, comportant en outre, entre l'étape b) de dépôt de la couche de matériau getter (108) et l'étape c) de réalisation de l'orifice (112, 112a), une étape de gravure d'une partie de la couche ou des couches (106, 108, 110) réalisées sur la portion de matériau sacrificiel (104), les portions restantes de ladite ou desdites couches (106, 108, 110) déposées formant un capot ou une partie d'un capot recouvrant la portion de matériau sacrificiel (104).

10. Procédé selon l'une des revendications précédentes, dans lequel l'étape e) de fermeture comporte le dépôt d'une couche (118) d'un matériau et/ou la réalisation d'au moins un bouchon (118), obstruant l'orifice (112) sur le matériau getter (108, 122) ou sur la couche d'herméticité (110).

11. Procédé selon la revendication 10, dans lequel le matériau et/ou le bouchon (118) obstruant l'orifice (112) sont à base d'un métal et/ou d'un oxyde et/ou d'un matériau getter.

12. Procédé selon l'une des revendications précédentes, comportant en outre, au cours de l'étape a) de réalisation de la portion de matériau sacrificiel (104), la formation d'au moins un second orifice dans la portion de matériau sacrificiel (104), les couches (106, 108, 110, 118) déposées au cours des étapes ultérieures étant également déposées dans ledit second orifice, formant au moins un micro-pilier (120) dans la cavité (114).

13. Procédé selon l'une des revendications précédentes, dans lequel la portion de matériau sacrificiel (104) a une épaisseur comprise entre environ 1 µm et 20 µm, et/ou le matériau sacrificiel étant à base de résine photosensible ou d'au moins un métal.

14. Procédé selon l'une des revendications précédentes, dans lequel la couche de matériau getter (108) a une épaisseur comprise entre environ 200 nm et 5 µm, et/ou le matériau getter étant à base de titane et/ou de zirconium et/ou de vanadium.

15. Procédé selon l'une des revendications précédentes, comportant en outre, après l'étape e) de fermeture de la cavité (114, 114a), une étape d'activation thermique du matériau getter (108, 122).

16. Procédé selon l'une des revendications précédentes, comportant en outre, entre l'étape c) de réalisation de l'orifice (112, 112a) et l'étape d) d'élimination, ou entre l'étape d) d'élimination et l'étape e) de fermeture, les étapes suivantes :
- réalisation d'une seconde portion de matériau sacrificiel sur la couche de matériau getter (108) ou sur la couche d'herméticité (110), dont le volume occupe un espace destiné à former au moins une partie d'une seconde cavité (114b),
- dépôt d'une seconde couche à base d'au moins un matériau getter et/ou d'une couche d'herméticité (110b) recouvrant au moins une partie de la seconde portion de matériau sacrificiel,
- réalisation d'au moins un second orifice (112b) à travers au moins la seconde couche de matériau getter et/ou la couche d'herméticité (110b), formant un accès à la seconde portion de matériau sacrificiel ;
et comportant en outre, entre l'étape de réalisation du second orifice et l'étape d) d'élimination, ou pendant l'étape d) d'élimination, ou entre l'étape d) d'élimination et l'étape e) de fermeture, une étape d'élimination d'au moins la seconde portion de matériau sacrificiel par le second orifice (112b), formant la seconde cavité (114b).

17. Procédé selon la revendication 16, comportant en outre, entre l'étape de dépôt de la seconde couche de matériau getter et/ou de la couche d'herméticité (110b) et l'étape de réalisation du second orifice (112b), une étape de gravure d'une partie de la couche ou des couches réalisées sur la seconde portion de matériau sacrificiel, les portions restantes de ladite ou desdites couches déposées formant un capot ou une partie d'un capot recouvrant la seconde portion de matériau sacrificiel.

18. Procédé selon l'une des revendications 16 ou 17, dans lequel l'étape e) de fermeture comporte le dépôt d'une couche (118) d'un matériau et/ou la réalisation d'au moins un bouchon (118), obstruant le second orifice (112b) sur la seconde couche de matériau getter et/ou sur la couche-d'herméticité (110b).

## Patentansprüche

1. Verfahren zur Verkapselung einer auf einem Substrat (102) angeordneten mikroelektronischen Vorrichtung (100), das wenigstens die folgenden Schritte umfasst:
a) Bilden eines Abschnitts aus Opfermaterial (104), der mindestens einen Teil der mikroelektronischen Vorrichtung (100) bedeckt und dessen Volumen einen Raum einnimmt, der zum Bilden mindestens eines Teils eines Hohlraums (114, 114a) bestimmt ist, in dem die Vorrichtung (100) verkapselt werden soll,
b) Aufbringen einer Schicht (108) aus wenigstens einem Gettermaterial, die mindestens einen Teil des Abschnitts aus Opfermaterial (104) bedeckt,
c) Bilden wenigstens einer Öffnung (112, 112a) durch wenigstens die Schicht aus Gettermaterial (108), wobei ein Zugang zu dem Abschnitt aus Opfermaterial (104) gebildet wird,
d) Entfernen des Abschnitts aus Opfermaterial (104) durch die Öffnung (112, 112a), wodurch der Hohlraum (114, 114a) gebildet wird, in dem die mikroelektronische Vorrichtung (100) verkapselt wird,
e) Verschließen des Hohlraums (114, 114a).

2. Verfahren gemäß Anspruch 1, bei dem in Schritt a) das Bilden des Abschnitts aus Opfermaterial (104) wenigstens das Durchrühren der folgenden Schritte umfasst:
a1) Aufbringen einer Schicht aus Opfermaterial auf das Substrat (102) und Bedecken mindestens der mikroelektronischen Vorrichtung (100),
a2) Formgebung eines Teils der Opferschicht, wobei ein Restabschnitt der Opferschicht diesen Abschnitt aus Opfermaterial (104) bildet.

3. Verfahren gemäß einem der vorangehenden Ansprüche, das außerdem zwischen dem Schritt a) des Bildens des Abschnitts aus Opfermaterial (104) und dem Schritt b) des Aufbringens der Schicht aus Gettermaterial (108) einen Schritt der thermischen Fließformung des Abschnitts aus Opfermaterial (104) umfasst.

4. Verfahren gemäß einem der vorangehenden Ansprüche, das außerdem zwischen dem Schritt a) des Bildens des Abschnitts aus Opfermaterial (104) und dem Schritt b) des Aufbringens der Schicht aus Gettermaterial (108) einen Schritt des Aufbringens einer Schutzschicht (106) auf den Abschnitt aus Opfermaterial (104) umfasst, wobei die Schicht aus Gettermaterial (108) während des Schritts b) auf die Schutzschicht (106) aufgebracht wird und die Öffnung (112, 112a) außerdem während des Schritts c) durch die Schutzschicht (106) gebildet wird.

5. Verfahren gemäß Anspruch 4, bei dem die Schutzschicht (100) eine Dicke zwischen etwa 10 nm und 1 µm aufweist und/oder auf Chrom und/oder Kupfer beruht.

6. Verfahren gemäß einem der vorangehenden Ansprüche, das außerdem zwischen dem Schritt b) des Aufbringens der Schicht aus Gettermaterial (108) und dem Schritt c) des Bildens der Öffnung (112, 112a) einen Schritt des Aufbringens einer Dichtheitsschicht (110) auf die Schicht aus Gettermaterial (108) umfasst, wobei die Öffnung (112, 112a) außerdem während des Schritts c) durch die Dichtheitsschicht (110) gebildet wird.

7. Verfahren gemäß Anspruch 6, das außerdem zwischen dem Schritt b) des Aufbringens der Schicht aus Gettermaterial (108) und dem Schritt des Aufbringens der Dichtheitsschicht (110) einen Schritt des Ätzens eines Teils der Schicht aus Gettermaterial (108) umfasst, wobei ein verbleibender Abschnitt (122) der Schicht aus Gettermaterial (108) teilweise den Abschnitt aus Opfermaterial (104) bedeckt.

8. Verfahren gemäß einem der Ansprüche 6 oder 7, bei dem die Dichtheitsschicht (110) eine Dicke zwischen etwa 500 nm und 10 µm aufweist und/oder auf Titan und/oder Chrom und/oder Kupfer und/oder wenigstens einem Metall und/oder einem gegenüber Wellenlängen im Arbeitsbereich der mikroelektronischen Vorrichtung (100) transparenten Material beruht.

9. Verfahren gemäß einem der vorangehenden Ansprüche, das außerdem zwischen Schritt b) des Aufbringens der Schicht aus Gettermaterial (108) und dem Schritt c) des Bildens der Öffnung (112, 112a) einen Schritt des Ätzens eines Teils der auf dem Abschnitt aus Opfermaterial (104) gebildeten Schicht oder der Schichten (106, 108, 110) umfasst, wobei die verbleibenden Abschnitte der aufgebrachten Schicht oder der Schichten (106, 108, 110) eine den Abschnitt aus Opfermaterial (104) bedeckende Abdeckung oder einen Teil einer Abdeckung bildet.

10. Verfahren gemäß einem der vorangehenden Ansprüche, bei dem der Schritt e) des Verschließens das Aufbringen einer Schicht (118) aus einem Material und/oder das Bilden wenigstens eines die Öffnung (108) verschließenden Stopfens (118) auf dem Gettermaterial (108, 122) oder auf der Dichtheitsschicht (110) umfasst.

11. Verfahren gemäß Anspruch 10, bei dem das die Öffnung (108) verschließende Material und/oder der Stopfen (118) auf einem Metall und/oder einem Oxid und/oder einem Gettermaterial beruhen.

12. Verfahren gemäß einem der vorangehenden Ansprüche, das außerdem während des Schritts a) des Bildens des Abschnitts aus Opfermaterial (104) das Bilden wenigstens einer zweiten Öffnung in dem Abschnitt aus Opfermaterial (104) umfasst, wobei die während der nachfolgenden Schritte aufgebrachten Schichten (106, 108, 110, 118) ebenfalls in dieser zweiten Öffnung aufgebracht werden, wobei wenigstens ein Mikropfeiler (120) in dem Hohlraum (114) gebildet wird.

13. Verfahren gemäß einem der vorangehenden Ansprüche, bei dem der Abschnitt aus Opfermaterial (104) eine Dicke zwischen etwa 1 µm und 20 µm aufweist und/oder das Opfermaterial auf einem lichtempfindlichen Harz oder wenigstens einem Metall beruht.

14. Verfahren gemäß einem der vorangehenden Ansprüche, bei dem die Schicht aus Gettermaterial (108) eine Dicke zwischen etwa 200 nm und 5 µm aufweist und/oder das Gettermaterial auf Titan und/oder Zirconium und/oder Vanadium beruht.

15. Verfahren gemäß einem der vorangehenden Ansprüche, das außerdem nach dem Schritt e) des Verschließens des Hohlraumes (114, 114a) einen Schritt der thermischen Aktivierung des Gettermaterials (108, (108) umfasst.

16. Verfahren gemäß einem der vorangehenden Ansprüche, das außerdem zwischen dem Schritt c) des Bildens der Öffnung (112, 112a) und dem Entfernungsschritt d) oder zwischen dem Entfernungsschritt d) und dem Schritt des Verschließens e) die folgenden Schritte umfasst:
- Bilden eines zweiten Abschnitts aus Opfermaterial auf der Schicht aus Gettermaterial (108) oder auf der Dichtigkeitsschicht (110), dessen Volumen einen zum Bilden wenigstens eines Teils eines zweiten Hohlraums (114b) bestimmten Raum einnimmt,
- Aufbringen einer zweiten, auf wenigstens einem Gettermaterial beruhenden Schicht und/oder einer mindestens einen Teil des zweiten Abschnitts aus Opfermaterial bedeckenden Dichtigkeitsschicht (110b),
- Bilden wenigstens einer zweiten Öffnung (112b) durch wenigstens die zweite Schicht aus Gettermaterial und/oder die Dichtigkeitsschicht (110b), wobei ein Zugang zum zweiten Abschnitt aus Opfermaterial gebildet wird,
und außerdem zwischen dem Schritt des Bildens der zweiten Öffnung und dem Entfernungsschritt d) oder während des Entfernungsschritts d) oder zwischen dem Entfernungsschritt d) und dem Schritt e) des Verschließens einen Schritt des Entfernens mindestens des zweiten Abschnitts aus Opfermaterial über die zweite Öffnung (112b) umfasst, wodurch der zweite Hohlraum (1114b) gebildet wird.

17. Verfahren gemäß Anspruch 16, das außerdem zwischen dem Schritt des Aufbringens der zweiten Schicht aus Gettermaterial und/oder der Dichtigkeitsschicht (110b) und dem Schritt des Bildens der zweiten Öffnung (112b) einen Schritt des Ätzens eines Teils der auf dem zweiten Abschnitt aus Opfermaterial gebildeten Schicht oder der Schichten umfasst, wobei die verbleibenden Abschnitte der aufgebrachten Schicht oder der Schichten eine den zweiten Abschnitt aus Opfermaterial bedeckende Abdeckung oder einen Teil einer Abdeckung bilden.

18. Verfahren gemäß einem der Ansprüche 16 oder 17, bei dem der Schritt e) des Verschließens das Aufbringen einer Schicht (118) aus einem Material und/oder das Bilden wenigstens eines die zweite Öffnung (112b) auf der zweiten Schicht aus Gettermaterial und/oder auf der Dichtheitsschicht (110b) verschließende Stopfens (118) umfasst.

## Claims

1. Method of encapsulating a microelectronic device (100) arranged on a substrate (102), comprising at least the following steps:
a) making of a portion of sacrificial material (104) covering at least one part of the microelectronic device (100), the volume of which occupies a space intended to form at least one part of a cavity (114, 114a) in which the device (100) is intended to be encapsulated,
b) deposition of a layer (108) comprising at least one getter material, covering at least one part of the portion of sacrificial material (104),
c) making of at least one orifice (112, 112a) through at least the layer of getter material (108), forming an access to the portion of sacrificial material (104),
d) elimination of the portion of sacrificial material (104) via the orifice (112, 112a), forming the cavity (114, 114a) in which the microelectronic device (100) is encapsulated,
e) sealing of the cavity (114, 114a).

2. Method according to claim 1, wherein step a) of making of the portion of sacrificial material (104) comprises at least the implementation of the following steps:
a1) deposition of a layer comprising the sacrificial material on the substrate (102) and covering at least the microelectronic device (100),
a2) shaping of a part of the sacrificial layer, a remaining portion of the sacrificial layer forming said portion of sacrificial material (104).

3. Method according to one of the preceding claims, further comprising, between step a) of making of the portion of sacrificial material (104) and step b) of deposition of the layer of getter material (108), a step of thermal flow of the portion of sacrificial material (104).

4. Method according to one of the preceding claims, further comprising, between step a) of making of the portion of sacrificial material (104) and step b) of deposition of the layer of getter material (108), a step of deposition of a protective layer (106) on the portion of sacrificial material (104), the layer of getter material (108) being deposited, during step b), on the protective layer (106), the orifice (112, 112a) being moreover made, during step c), through the protective layer (106).

5. Method according to claim 4, wherein the protective layer (106) has a thickness between around 10 nm and 1 µm and/or comprises chromium and/or copper.

6. Method according to one of the preceding claims, further comprising, between step b) of deposition of the layer of getter material (108) and step c) of making of the orifice (112, 112a), a step of deposition of a hermeticity layer (110) on the layer of getter material (108), the orifice (112, 112a) being moreover made, during step c), through the hermeticity layer (110).

7. Method according to claim 6, further comprising, between step b) of deposition of the layer of getter material (108) and the step of deposition of the hermeticity layer (110), a step of etching a part of the layer of getter material (108), a remaining portion (122) of the layer of getter material (108) partially covering the portion of sacrificial material (104).

8. Method according to one of claims 6 or 7, wherein the hermeticity layer (110) has a thickness between around 500 nm and 10 µm, and/or comprises titanium and/or chromium and/or copper and/or at least one metal and/or a material transparent to a range of operating wavelengths of the microelectronic device (100).

9. Method according to one of the preceding claims, further comprising, between step b) of deposition of the layer of getter material (108) and step c) of making of the orifice (112, 112a), a step of etching a part of the layer or layers (106, 108, 110) made on the portion of sacrificial material (104), the remaining portions of said deposited layer(s) (106, 108, 110) forming a cover or a part of a cover covering the portion of sacrificial material (104).

10. Method according to one of the preceding claims, wherein step e) of stealing comprises the deposition of a layer (118) of a material and/or the making of at least one plug (118), obstructing the orifice (112) on the getter material (108, 122) or on the hermeticity layer (110).

11. Method according to claim 10, wherein the material and/or the plug (118) obstructing the orifice (112) comprise a metal and/or an oxide and/or a getter material.

12. Method according to one of the preceding claims, further comprising, during step a) of making of the portion of sacrificial material (104), the formation of at least one second orifice in the portion of sacrificial material (104), the layers (106, 108, 110, 118) deposited during subsequent steps also being deposited in said second orifice, forming at least one micro-pillar (120) in the cavity (114).

13. Method according to one of the preceding claims, wherein the portion of sacrificial material (104) has a thickness between around 1 µm and 20 µm, and/or the sacrificial material comprising a photosensitive resin or at least one metal.

14. Method according to one of the preceding claims, wherein the layer of getter material (108) has a thickness between around 200 nm and 5 µm, and/or the getter material comprising titanium and/or zirconium and/or hafnium.

15. Method according to one of the preceding claims, further comprising, after step e) of sealing of the cavity (114, 114a), a step of thermal activation of the getter material (108, 122).

16. Method according to one of the preceding claims, further comprising, between step c) of making of the orifice (112, 112a) and step d) of elimination, or between step d) of elimination and step e) of sealing, the following steps:
- making of a second portion of sacrificial material on the layer of getter material (108) or on the hermeticity layer (110), the volume of which occupies a space intended to form at least one part of a second cavity (114b),
- deposition of a second layer comprising at least one getter material and/or of a hermeticity layer (110b) covering at least one part of the second portion of sacrificial material,
- making of at least one second orifice (112b) through at least the second layer of getter material and/or the hermeticity layer (110b), forming an access to the second portion of sacrificial material;
and further comprising, between the step of making of the second orifice and step d) of elimination, or during step d) of elimination, or between step d) of elimination and step e) of sealing, a step of elimination of at least the second portion of sacrificial material via the second orifice, (112b), forming the second cavity (114b).

17. Method according to claim 16, further comprising, between the step of deposition of the second layer of getter material and/or the hermeticity layer (110b) and the step of making of the second orifice (112b), a step of etching a part of the layer or layers made on the second portion of sacrificial material, the remaining portions of said deposited layer (s) forming a cover or a part of a cover covering the second portion of sacrificial material.

18. Method according to one of claims 16 or 17, wherein step e) of sealing comprises the deposition of a layer (118) of a material and/or the making of at least one plug (118), obstructing the second orifice (112b) on the second layer of getter material and/or on the hermeticity layer (110b).
